# EUROPEAN PATENT APPLICATION

(11) **EP 4 803 897 A1**
(43) Date of publication of application: **09.09.2026**
(21) Application number: 26162506.5
(22) Date of filing: 05.03.2026
(51) Int. Cl.: G01N 27/90, H05K 1/02, H05K 3/12, H05K 3/46

(54) **CONFORMABLE SENSORS AND METHODS OF MANUFACTURING CONFORMABLE SENSORS**

(30) Priority: 07.03.2025 US 202563768647 P
(71) Applicant: General Electric Company, Evendale, Ohio 45215 (US)
(72) Inventor: PAVINATTO, Felippe Jose, Niskayuna, 12309-1027 (US); TRIVEDI, Deepak, Niskayuna, 12309-1027 (US); KOYITHITTA MEETHAL, Manoj Kumar, 560066 Bengaluru (IN); SHEILA VADDE, Aparna Chakrapani, 560066 Bengaluru (IN)
(74) Representative: Openshaw & Co.

(57) **Abstract**

Provided herein are conformable sensor assemblies and methods for manufacturing conformable sensor assemblies. In some embodiments, a method of manufacturing a conformable sensor assembly (100A, 100B, 100C) includes printing a high-resolution sensor element (106, 204, 604) on a first layer (102, 102B, 206, 306) using at least one of an electrohydrodynamic inkjet or an ultra-high resolution micro-dispensing process. The first layer (102, 102B, 206, 306) comprises a flexible or a stretchable substrate. The method also includes printing a mid-resolution sensor element (116, 304) on a second sensor layer (206, 306) using at least one of an aerosol, inkjet jet, screen-printing, or copper etching process. The second sensor layer (206, 306) is made from a flexible or a stretchable substrate. The mid-resolution sensor element (116, 304) having a trace spacing (606) in the range of about 20 microns to about 100 microns. The high-resolution sensor element (106, 204, 604) has a trace spacing (606) of less than about 20 microns. The first layer (102, 102B, 206, 306) is coupled with the second sensor layer (206, 306) to form a sensor assembly (100A, 100B, 100C).

## Description

### CROSS-REFERENCE TO RELATED APPLICATIONS

This application claims the benefit of priority of U.S. Provisional Application No. 63/768,647 filed March 7, 2025, which is herein incorporated by reference in its entirety.

### TECHNICAL FIELD

These teachings relate generally to sensors and more particularly to conformable sensors and methods of manufacturing conformable sensors.

### BACKGROUND

Composite and metal structures with complex geometries (e.g., curved surfaces) can be difficult to inspect. Traditional inspection methods often require contact between a sensor and the component being inspected. However, the inspection of components with complex geometries (e.g., a gas turbine engine) can be difficult due to the lack of conformability of many traditional sensors. Accordingly, conformable sensors and methods of manufacturing conformable sensors for complex geometries may be desirable.

### BRIEF DESCRIPTION OF DRAWINGS

Various needs are at least partially met through provision of the conformable sensors and methods of manufacturing the conformable sensors described in the following detailed description, particularly when studied in conjunction with the drawings. A full and enabling disclosure of the aspects of the present description, including the best mode thereof, directed to one of ordinary skill in the art, is set forth in the specification, which refers to the appended figures, in which:
FIG. 1A is an exploded, perspective view of a sensor assembly including a first layer and a second layer, in accordance with various embodiments of these teachings;
FIG. 1B is an exploded, perspective view of a sensor assembly with a first layer and a second layer, with the first layer including plurality of first layers, in accordance with various embodiments of these teachings;
FIG. 1C is an exploded, perspective view of a sensor assembly with a first layer and a second layer, with the first layer including an array of sensor elements, in accordance with various embodiments of these teachings;
FIGS. 2A, 2B, 2C, 2D, 2E, and 2F are perspective views of a high-resolution layer and a method of making the high-resolution layer in accordance with various embodiments of these teachings;
FIGS. 3A, 3B, 3C, 3D, 3E, and 3F are perspective views of a mid-resolution layer and a method of making the mid-resolution layer in accordance with various embodiments of these teachings;
FIGS. 4A, 4B, and 4C are perspective views of a coupling surface or interconnect for a sensor assembly and a method of making the coupling surface or interconnect, in accordance with various embodiments of these teachings;
FIG. 5 is a flow diagram of a method of making a sensor assembly, in accordance with various embodiments of these teachings;
FIG. 6 is an illustration of a high-resolution sensor element, in accordance with various embodiments of these teachings; and
FIG. 7 is an illustration of a high-resolution sensor element, in accordance with various embodiments of these teachings.

Elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present teachings. Also, common but well-understood elements that are useful or necessary in a commercially feasible embodiment are often not depicted in order to facilitate a less obstructed view of these various embodiments of the present teachings. Certain actions and/or steps may be described or depicted in a particular order of occurrence while those skilled in the art will understand that such specificity with respect to sequence is not actually required.

### DETAILED DESCRIPTION

The methods of making the conformable sensors described herein provide a scalable manufacturing method for fabricating conformable sensors which may be used for inspecting composite and metal structures with complex geometries. More specifically, the approaches described herein involve a modular sensor design, for example, that includes a first layer that is flexible or stretchable with high-resolution sensor elements and a second layer that is flexible or stretchable with mid resolution sensor elements. Such a modular design may provide advantages in comparison with a monolithic sensor assembly. For example, the second layer can be made with a higher throughput (e.g., faster) manufacturing method since it does not involve printing high-resolution elements. The sensors and manufacturing methods use anisotropic conductive materials as an asymmetrically conductive interface to couple and interconnect the stretchable and flexible layers, which may eliminate the need for precise alignment during manufacturing.

Traditional approaches for inspecting composite and metal structures may use flexible sensors such as, for example, flexible printed circuit boards. However, such traditional flexible sensors are not conformable to three-dimensional curvatures. Further, traditional manufacturing approaches are generally unable to create high-resolution sensor elements on stretchable materials. Thus, sensors made with stretchable materials lack adequate trace density for capturing high-resolution sensing data to detect material flaws and defects. In addition, traditional approaches for manufacturing flexible sensors lack the complexity and miniaturization capabilities to support dense and functional miniaturized sensing devices and electronics.

Advantageously, the conformable sensors and methods for making conformable sensors described herein can be used for the fabrication of multi-layer, high-resolution conformable sensors with improved density and performance. The methods of making a conformable sensor described herein include printing one or more high-resolution sensor elements on a first layer using an electrohydrodynamic (EHD) inkjet or ultra-high resolution micro-dispensing processes, and printing one or more mid-resolution sensor elements on a second layer using at least one of an aerosol, an inkjet jet, a screen-printing process, or a copper etching process. The first layer and the second layer can be made from a stretchable or a flexible substrate. The method further includes coupling the first layer with the second layer to form a sensor assembly. The sensor assembly can be used for sensing and inspecting parts and components of an engine, such as a gas turbine engine. Example components include but are not limited to fan discs/blades, compressor disc/blades, composite casing, etc.

In the methods described herein, a high-resolution sensor element can be printed on a flexible or a stretchable substrate using an EHD inkjet or an ultra-high resolution micro-dispensing process to achieve high-density traces. These high-density traces result in a sensor that is configured for high-resolution sensing. The methods use lower resolution sensor elements (e.g., mid-resolution sensor elements) that are to be printed on the flexible or stretchable substrate using an aerosol jet, inkjet, screen-printing, or copper etching process. In this manner, the sensor assembly incorporates a hybrid design with both flexible and stretchable substrates. A flexible substrate is preferred for layer one to facilitate high-resolution printing, overcoming challenges associated with printing high-resolution sensor elements on stretchable substrates. However, the use of stretchable substrates is also possible in layer one. The use of stretchable substrates for the second layer provides conformability so that the final sensor assembly is able to conform to an inspection surface.

The terms and expressions used herein have the ordinary technical meaning as is accorded to such terms and expressions by persons skilled in the technical field as set forth above except where different specific meanings have otherwise been set forth herein. The word "or" when used herein shall be interpreted as having a disjunctive construction rather than a conjunctive construction unless otherwise specifically indicated. The terms "coupled," "fixed," "attached to," and the like refer to both direct coupling, fixing, or attaching, as well as indirect coupling, fixing, or attaching through one or more intermediate components or features, unless otherwise specified herein.

The singular forms "a", "an", and "the" include plural references unless the context clearly dictates otherwise.

As used herein, "flexible" refers to a material with the ability to flex, bend, or deform without breaking. In some examples, a flexible material (e.g., a substrate) may flex to a bending radius of up to 0.3 millimeter (mm) while still preserving its mechanical properties. Suitable flexible materials that can be used in the flexible layers described herein include but are not limited to polyethylene terephthalate (PET); polycarbonate (PC); polyethylene naphthalene (PEN); polyethylene (PE); polypropylene (PP); and polyimide (Kapton).

As used herein, "stretchable" refers to a material with a modulus less than or equal to 60 megapascals (MPa) and the ability to bend, stretch, or deform without breaking. In some examples, the material may stretch at break of greater than or equal to 25%. In other words, the material may be stretched to more than 125% of the original length before failure. In some aspects, a stretchable material may recover its original dimensions within about a 5 percent (%) tolerance when strain is removed, after elongation below the breaking limits specified above. This recovery may show time dependency and take a number of seconds or minutes to occur. Suitable stretchable materials that can be used in the stretchable layers described herein include but are not limited to thermoplastic poly-urethanes (TPU); silicones such as polydimethylsiloxane (PDMS), etc.; and styrene-ethylene-butylene-styrene (SEBS).

As used herein, "trace" refers to a sensor element used to conduct electrical signals throughout one or more layers of a sensor assembly. In some examples, the trace may include drive coils, sense coils, and the like.

As used herein, "high-resolution" refers to line width and/or line spacing between adjacent lines of less than 20 microns (µm).

As used herein, "mid-resolution" refers to line width and/or line spacing between adjacent lines in the range of about 20 to about 100 microns (µm).

As used herein, "low-resolution" refers to line width and/or line spacing between adjacent lines of greater than 100 microns (µm).Approximating language, as used herein throughout the specification and claims, is applied to modify any quantitative representation that could permissibly vary without resulting in a change in the basic function to which it is related. Accordingly, a value modified by a term or terms such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

As used herein, the terms "first", "second", and "third" may be used interchangeably to distinguish one component from another and are not intended to signify location or importance of the individual components.

The foregoing and other benefits may become clearer upon making a thorough review and study of the following detailed description.

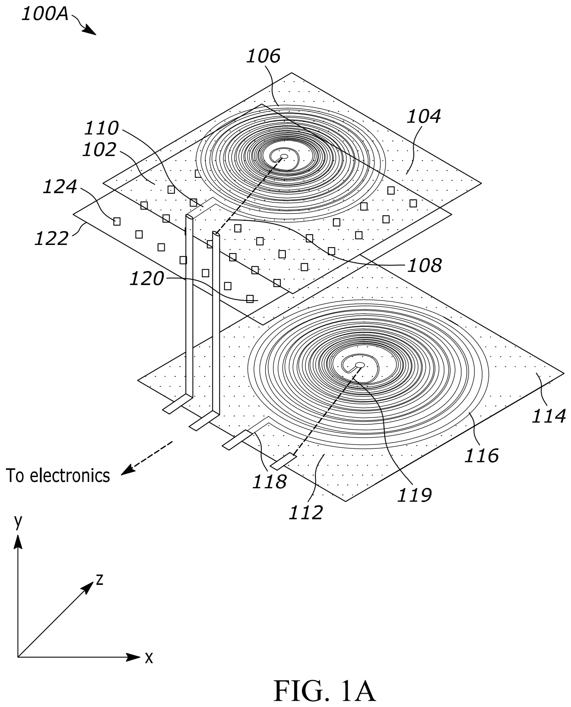

Referring now to the drawings, and in particular to FIGS. 1A-1C, perspective views of sensor assemblies 100A, 100B, 100C in accordance with various embodiments are provided.

FIG. 1A illustrates a sensor assembly 100A with a first layer 102, a second layer 112, and an asymmetrically conductive interconnect 120. The asymmetrically conductive interconnect 120 is disposed between the first layer 102 and the second layer 112.

The first layer 102 includes a first substrate 104 and a high-resolution sensor element 106 printed on the first substrate 104. Any type or number of high-resolution sensor elements 106 can be printed on the first substrate 104 depending on the application. In the illustrated embodiment, the high-resolution sensor element 106 is a coil (e.g., a sense coil or a drive coil for an eddy current sensor). The high-resolution sensor element 106 includes a first trace 108 and a second trace 110. The first trace 108 and the second trace 110 are printed on the first substrate 104. The first trace 108 is electrically coupled at a center portion of the high-resolution sensor element 106. The second trace 110 is electrically coupled at an end portion of the high-resolution sensor element 106.

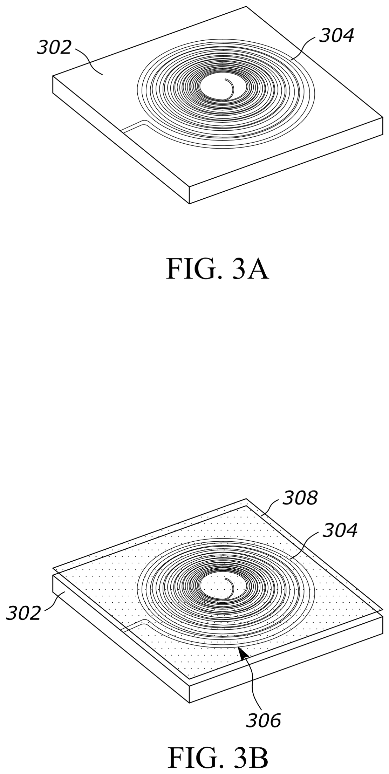

In some embodiments, the high-resolution sensor element 106 is formed from at least one of copper, gold, or silver. In some aspects, the high-resolution sensor element(s) 106 is/ are formed via sintering of nanoparticles or via particle-free inks, generating a granular structure on the substrate (e.g., a conductive metal film) with distinguishable grain sizes in the order of tens of nanometers in length. Further, the high-resolution sensor element(s) 106 may have line edges with a variation of up to 20 percent of a line width of the high-resolution sensor element 106. The first layer 102 may include multiple layers (referred to as "sub-layers") stacked on top of each other, as illustrated in the process flow in FIGS. 3A-3F.

The first substrate 104 may be formed from a flexible material (i.e., a flexible substrate), or alternatively, a stretchable material (i.e., a stretchable substrate).

The second layer 112 includes a second substrate 114, and a mid-resolution sensor element 116 printed on the second substrate 114. In some embodiments, the mid-resolution sensor element 116 is a coil, such as a drive coil or a sense coil. Mid-resolution sensor elements 116 may be printed on the sub-layer of the second layer 112. In addition, third traces 118 and fourth traces 119 are printed on the second layer 112. The third traces 118 may extend in the side of the mid-resolution sensor element 116 from the asymmetrically conductive interconnect 120 to the electrical measurement and analysis system (not shown in FIG. 1A-1C). The third traces 118 may be printed in a layer (e.g., an interlayer) that is separate from the second layer 112 and overlayed on the second layer 112. The fourth trace 119 is electrically coupled at a center portion of the mid-resolution sensor element 116. The third trace 118 is electrically coupled at an end portion of the mid-resolution sensor element 116.

The second substrate 114 may be formed of a stretchable material (i.e., a stretchable substrate), or alternately, a flexible material (i.e., a flexible substrate).

In some embodiments, an electronic measurement and analysis system (not shown) is electrically coupled to the first layer 102 and the second layer 112, and more particularly, to the mid-resolution sensor element 116. The electronic measurement and analysis system may be any suitable system. For example, the electronic measurement and analysis system may include eddy current (EC) instrumentation to supply an excitation current to the mid-resolution sensor element 116 (e.g., inducing eddy currents in the material being tested) such that the mid-resolution sensor element 116 acts as a drive coil, to measure the resulting signals of the high-resolution sensor element 106, and/or to process the signals received from the high-resolution sensor element 106. In some embodiments, a multiplexer (not shown) is coupled to the electronic measurement and analysis system.

In some embodiments, an excitation source (not shown) is electrically coupled to the second layer 112, and more particularly, to the mid-resolution sensor element116. The excitation source may be any suitable source such as, for example, a voltage source or a current source. In this manner, the excitation source generates a current which flows through the mid-resolution sensor element 116 to the probed sample.

As shown in FIG. 1A, the sensor assembly 100A includes the asymmetrically conductive interconnect 120 disposed between the first layer 102 and the second layer 112. The asymmetrically conductive interconnect 120 forms a coupling interface to align the first layer 102 and the second layer 112 during manufacturing. More specifically, the asymmetrically conductive interconnect 120 couples and interconnects the first layer 102 and the second layer 112. The asymmetrically conductive interconnect 120 can be formed of a dielectric material 122 containing conductive, magnetic microparticles 124 dispersed in the dielectric material 122. The dielectric material 122 can be applied as a liquid resin or as a film. An external magnetic field is used to orient the magnetic microparticles 124 in the dielectric material 122 and to form an electrical percolating path perpendicular or substantially perpendicular to the film surface. A non-magnetic asymmetrically conductive film or material can be used as an alternative to form the asymmetrically conductive interconnect 120.

The dielectric material 122 and deposition process described above can be used to form an anisotropically conductive layer on the surface of the first layer 102 in an electrical impedance tomography (EIT) sensor embodiment. The asymmetrically conductive interconnect 120 may comprise at least one of an anisotropically conductive ink or an anisotropically conductive film. Advantageously, the anisotropically conductive electrode material eliminates the need for precise alignment between the first trace 108, the second trace 110 and the third trace 118 to electrical circuit pads during manufacturing.

The anisotropic conductive material in the asymmetrically conductive interconnect 120 is configured to conduct electricity in specific directions and act as insulators in other directions. In some embodiments, the anisotropic conductive material is configured to allow electrical conductivity primarily along the Z-axis direction (e.g., perpendicular to a surface plane of the first layer 102), while providing insulation along the X and Y axes (e.g., along the surface plane of the first layer 102). As such, the directional conductivity ensures efficient signal transmission between the first trace 108 and the second trace 110 on the first layer 102 and the third traces 118 on the second layer 112 onto circuit lines on the edge of the substrates. Locating the end of the high-resolution traces 108, 110 coming out of the first layer 102 (e.g., in the region between the high-resolution sensor element 106 and the edge of the first layer 102) and aligning to the traces 108, 110 when assembling the first layer 102 and the second layer 112 together may be challenging. The use of the anisotropic conductive material simplifies this operation and alleviates alignment tolerances. Since there are multiple through-substrate conductive columns in the anisotropic conductive material, large pads on the second layer 112 can be aligned to an area that "roughly" overlaps with the end of the high-resolution trace 108, 110. There should be a conductive path in the overlapping area to make the connection between the first layer 102 and the second layer 112. In addition, the anisotropically conductive material is highly compliant. In other words, the compliance (e.g., flexibility) of the anisotropically conductive material allows the asymmetrically conductive interconnect 120 to adapt to curved, or irregular surfaces without a loss in electrical properties when the anisotropic material is applied to a surface of the first layer 102.

The first layer 102 and the second layer 112 are coupled together to form the sensor assembly 100A. In some embodiments, the first layer 102 is coupled axially in line with the second layer 112 and the asymmetrically conductive interconnect 120 is disposed between the first layer 102 and the second layer 112. More specifically, the first layer 102 is positioned adjacent a first side of the asymmetrically conductive interconnect 120 and the second layer 112 is positioned adjacent a second side of the asymmetrically conductive interconnect 120 opposite the first layer 102. In this configuration, the bottom side of the first layer 102 is covered with a dielectric film, and only the terminations of traces 108 and 110 are exposed to make contact with the conductive columns in the asymmetrically conductive interconnect 120.

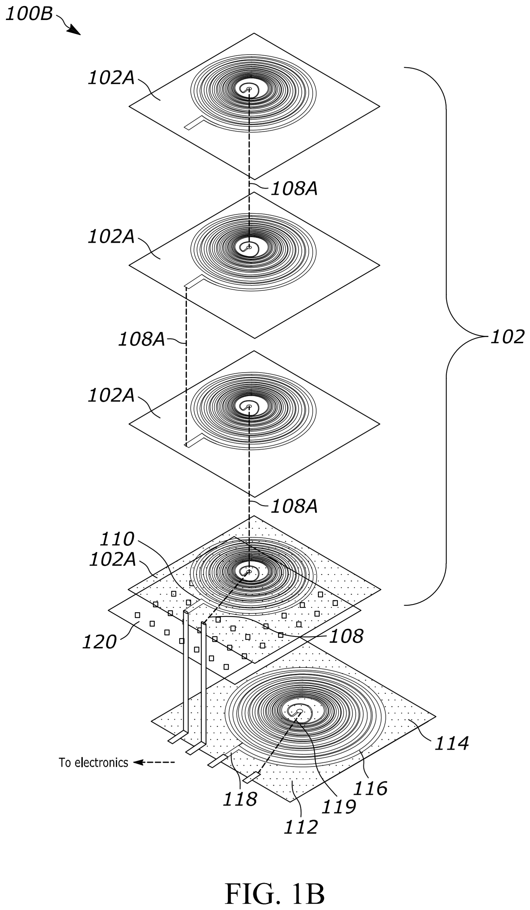

FIG. 1B shows a sensor assembly 100B where the first layer 102 is a multi-layer sensor element. In FIG. 1B, the first layer 102 is formed from a plurality of layers 102A. In some aspects, the layers 102A have the same structure as the first layer 102 that is described with reference to FIG. 1A. Though four layers 102A are shown in FIG. 1B, it is contemplated that the sensor assembly 100B can include any suitable number of layers 102A. The layers 102A are stacked on top of each other and substrate vias 108A electrically couple the sensor elements of the layers 102A. The sensor assembly 100B further includes the asymmetrically conductive interconnect 120 and the second layer 112 that are described with reference to FIG. 1A.

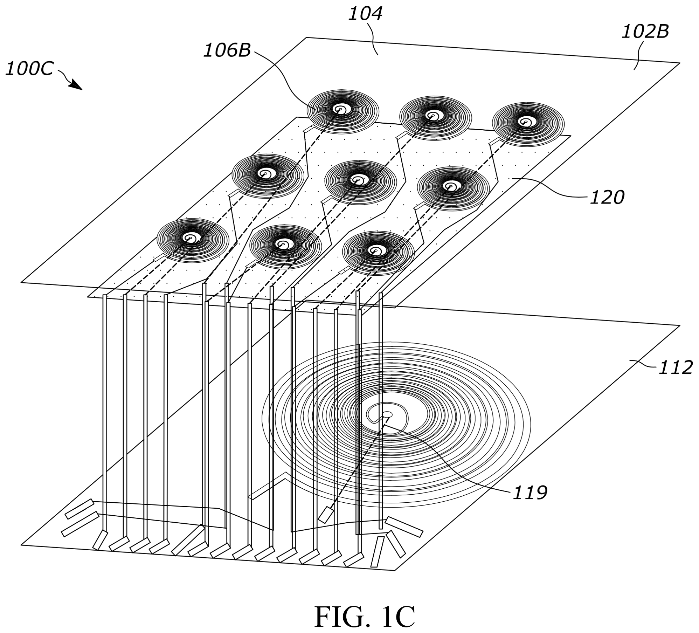

FIG. 1C shows a sensor assembly 100C with a first layer 102B that includes an array of high-resolution sensor elements 106B. The first layer 102B has the same structure as the first layer 102 described with reference to FIG. 1A, with a difference being that a plurality of high-resolution sensor elements 106B are disposed on the first substrate 104 rather than a single high-resolution sensor element 106. The sensor assembly 100C further includes the asymmetrically conductive interconnect 120 and the second layer 112 that are described with reference to FIG. 1A. It is contemplated that while any array of nine high-resolution sensor elements 106B is depicted in the embodiment of FIG. 1C, any suitable number of high-resolution sensor elements 106B may be included (e.g., 1, 2, 3, 6, 12, etc.). Also, the number of columns and rows in the array do not necessarily need to be the same.

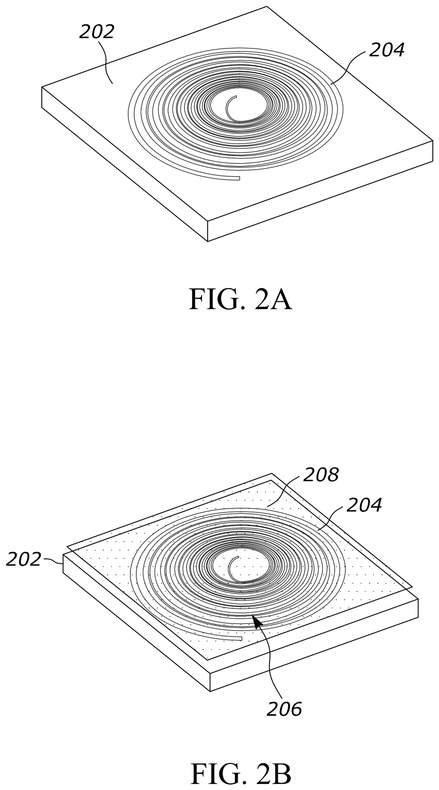

FIGS. 2A-2F illustrate perspective views at various stages of an exemplary method of manufacturing a stretchable layer or a flexible layer of a sensor assembly. In some embodiments, the sensor assembly may be an eddy current inspection assembly. In some embodiments, the method of manufacturing may be used to manufacture the first layer 102 of the sensor assemblies 100A, 100B, 100C as shown in FIGS. 1A-1C. Although the following description of the method of manufacturing is described in a particular order, which represents a particular embodiment, it should be noted that the method of manufacturing may be performed in any suitable order. Further, certain steps may be repeated or skipped altogether, and additional steps may be included.

In some embodiments, the method is used to manufacture the first layer 102 (e.g., a high-resolution layer) that is shown and described with reference to FIG. 1A-1C.

The method begins with a base film 202 as illustrated in FIG. 2A. The base film 202 supports a dielectric layer 208 (see FIG. 2B) during the fabrication process. A high-resolution sensor element 204 is printed on the base film 202 using an electrohydrodynamic (EHD) inkjet or ultra-high resolution micro-dispensing process. In some embodiments, the high-resolution sensor element 204 is a coil. In other embodiments, the high-resolution sensor element 204 is a serpentine conductor or a conductor having another circuit layout.

In the EHD inkjet process, an electric field is used to precisely eject ink droplets from a nozzle onto a substrate. High-resolution printing is enabled by manipulating the surface tension of the ink through electrostatic forces, which pulls as opposed to pushing the ink out of the nozzle. The use of the electric field instead of mechanical or thermal transducers like in more conventional piezoelectric or thermal inkjet variations allows the application of over 10 times more energy to the fluid in the EHD inkjet process. This results in smaller droplets being jetted from the printing nozzle at higher speeds, which affords an order of magnitude improvement in feature sizes with this technology.

In the ultra-high resolution micro-dispensing process, similar high-resolution printing (below 20 microns) is achieved with the combination of high precision pressure application control, high-precision nozzle placement close to the printing surface, and optimized ink rheology. The ultra-high resolution micro-dispensing process usually operates on a continuous ink deposition fashion instead of a drop-on-demand manner as in inkjet. Ink viscosities can vary between 1 centipoise (cP) and 1,000,000 cP, but are preferably in the 100,000 cP to 1,000,000 cP range in the ultra-high resolution micro-dispensing process. Here, particle free or nanoparticle-based metal inks are also preferred.

Subsequently, as illustrated in FIG. 2B, a dielectric layer 208 is formed on the base film 202. The dielectric layer 208 can be a flexible substrate or a stretchable substrate. The dielectric layer 208 may provide signal shielding to help to improve a signal-to-noise ratio of the device to reduce interference. In some approaches, the dielectric layer 208 is formed by laminating the base film 202 with a thermoplastic polyurethane (TPU), a silicone material, or any other suitable dielectric material. In one example, the base film 202 may be laminated with a TPU film, which is applied over the base film 202 and bonded using heat and pressure to form the dielectric layer 208. In another example, the base film 202 may be laminated with a silicone material, which is applicated over the base film 202 and cured to form the dielectric layer 208. Together, the high-resolution sensor element 204 and the dielectric layer 208 form a layer 206 of a sensor assembly (e.g., as the first layer 102 of the sensor assembly 100A, 100B, or 100C).

In other approaches, the dielectric layer 208 is formed by depositing a liquid resin on the base film 202 by drop-casting or printing. In one example, liquid resin droplets are uniformly spread on the base film 202 and cured using heat or UV light to form the dielectric layer 208. In another example, liquid resin is printed (e.g., selectively deposited) onto the base film 202 and cured using heat or UV light to form the dielectric layer 208.

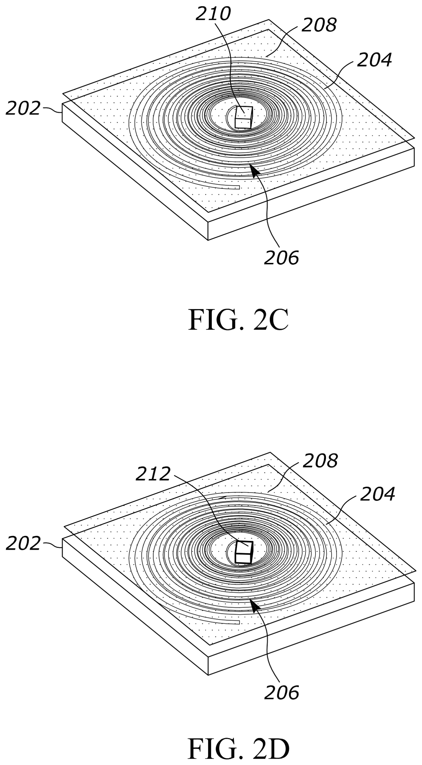

After the dielectric layer 208 is formed on the base film 202, a via 210 is formed in the dielectric layer 208 as illustrated in FIG. 2C. In some approaches, the via 210 is drilled in the dielectric layer 208. The via 210 can be formed in any suitable manner and, in some examples, is formed using at least one of laser drilling or solvent etching. In laser drilling, a focused laser beam may be directed onto the dielectric layer 208 to ablate a portion of the dielectric layer 208 to form the via 210. Alternatively, in solvent etching, the dielectric layer 208 may be exposed to a solvent to dissolve a portion of the dielectric layer 208 to from the via 210. The via 210 is then filled with a conductive material 212 using a printing process as illustrated in FIG. 2D. Suitable printing processes may include, but are not limited to, at least one of aerosol jet printing, micro-dispensing, inkjet printing, or stencil printing. Alternatively, a copper etching process can be employed. The conductive material 212 may be any suitable conductive material.

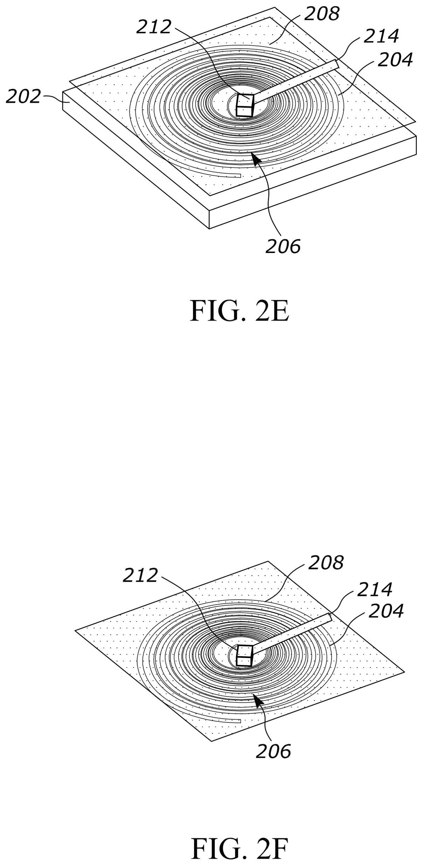

Next, as illustrated in FIG. 2E, a top interconnect 214 is formed on the dielectric layer 208 using a printing process. The printing process may include any suitable printing process to create the top interconnect 214. In some embodiments, the top interconnect 214 is a high-resolution interconnect. Suitable printing processes for forming the top interconnect 214 may include, but are not limited to, at least one of aerosol jet printing, micro-dispensing, inkjet printing, screen-printing, direct-write printing, or stencil printing. It is contemplated that the top interconnect 214 formed by these processes provides electrically conductive pathways and maintains functionality when the base film 202 is removed, for example, under stretch, bending, or twisting.

The base film 202 is removed from the high-resolution sensor element 204 as illustrated in FIG. 2F. Suitable removal processes may include, but are not limited to, at least one of peeling off the base film 202 via an ultraviolet (UV) radiation or thermally induced release or dissolution via water and/or a solvent when the base film 202 is soluble. The removal of the base film 202 exposes the high-resolution sensor element 204 to obtain a free-standing sensor. In this manner, the high-resolution sensor element 204 may contact an external surface (e.g., an aerospace surface) under test during sensing applications.

Once the base film 202 is removed, the high-resolution sensor element 204 and the dielectric layer 208 are left as a free-standing layer 206 for a sensor assembly (e.g., as the first layer 102 of the sensor assembly 100A, 100B, or 100C). If necessary for a particular inspection method, for instance, Eddy Current, the release film may be kept at the electrode surface for sensor use. In this manner, the release film can be used to provide an insulating film for the sensor assembly. When the sensor assembly is an Eddy Current sensor assembly the release film can serve as an insulator so that a metal sensor element (e.g., coil) does not touch a metal surface under inspection.

FIGS. 3A-3F illustrate perspective views at various stages of an exemplary method of manufacturing a sensor layer for a sensor assembly. In some embodiments, the method of manufacturing may be used to manufacture a mid-resolution layer (e.g., the second layer 112 of the sensor assemblies shown in FIGS. 1A-1C). Although the following description of the method of manufacturing is described in a particular order, which represents a particular embodiment, it should be noted that the method of manufacturing may be performed in any suitable order. Further, certain steps may be repeated or skipped altogether, and additional steps may be included.

In some embodiments, the method is used to manufacture the second layer 112 (e.g., a mid-resolution layer) that is shown and described with reference to FIGS. 1A-1C.

The method begins with a mid-resolution sensor element 304 which is formed on a base film 302 as illustrated in FIG. 3A. The base film 302 supports the mid-resolution sensor element 304 during the fabrication process. A mid-resolution sensor element 304 is printed on the base film 302 using at least one of an aerosol, inkjet jet, screen-printing, or copper etching process. In some embodiments, the mid-resolution sensor element 304 is a coil. In other embodiments, the mid-resolution sensor element 304 is a serpentine conductor or another conductive circuit layout.

Subsequently, as illustrated in FIG. 3B, a dielectric layer 308 is formed on the base film 302 and the mid-resolution sensor element 304. The dielectric layer 308 can be a flexible substrate or a stretchable substrate. In some approaches, the dielectric layer 308 is formed by laminating the base film 302 with a thermoplastic polyurethane (TPU), a silicone material, or any other suitable dielectric material. In one example, the base film 302 may be laminated with a TPU film, which is applied over the base film 302 and bonded using heat and pressure to form the dielectric layer 308. In another example, the base film 302 may be laminated with a silicone material, which is applicated over the base film 302 and cured to form the dielectric layer 308.

In other approaches, the dielectric layer 308 is formed by depositing a liquid resin on the base film 302 by drop-casting or printing. In one example, liquid resin droplets are uniformly spread on the base film 302 and cured using heat or UV light to form the dielectric layer 308. In another example, liquid resin is printed (e.g., selectively deposited) onto the base film 302 and cured using heat or UV light to form the dielectric layer 308. Together, the mid-resolution sensor element 304 and the dielectric layer 308 form a layer 306 of a sensor assembly.

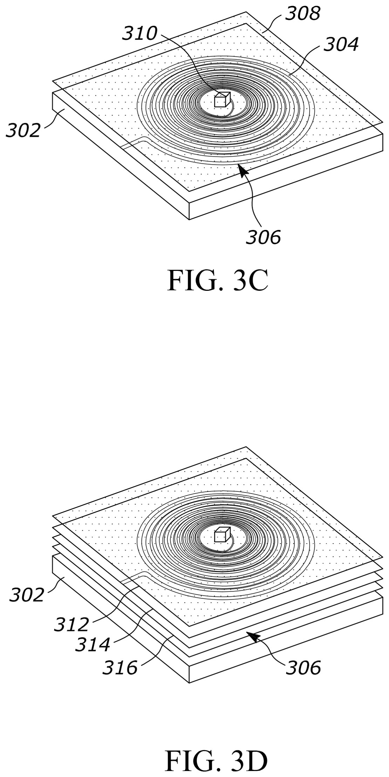

After the dielectric layer 308 is formed on the base film 302 and the mid-resolution sensor element 304, a via 310 is formed in the dielectric layer 308 as illustrated in FIG. 3C. The via 310 is drilled in the dielectric layer 308. The via 310 can be formed in any suitable manner and, in some aspects, is formed using at least one of laser drilling or solvent etching. In laser drilling, a focused laser beam may be directed onto the dielectric layer 308 to ablate a portion of the dielectric layer 308 to form the via 310. Alternately, in solvent etching, the dielectric layer 308 may be exposed to a solvent to dissolve a portion of the dielectric layer 308 to from the via 310.

The stages of manufacturing as illustrated in FIGS. 3A-3C may be sequentially repeated to form one or more additional sensor layers 312, 314, 316 stacked on the base film 302 as illustrated in FIG. 3D. In some embodiments, the additional sensor layers 312, 314, 316 comprise a stretchable substrate. In some embodiments, the additional sensor layers 312, 314, 316 comprise a flexible substrate. It is contemplated that while FIG. 3D illustrates three additional sensor layers, the stages of manufacturing as illustrated in FIGS. 3A-3C may be repeated any suitable number of times and the corresponding sensors layers stacked on the base film 302. In one non-limiting example, the stages of manufacturing may be repeated four times.

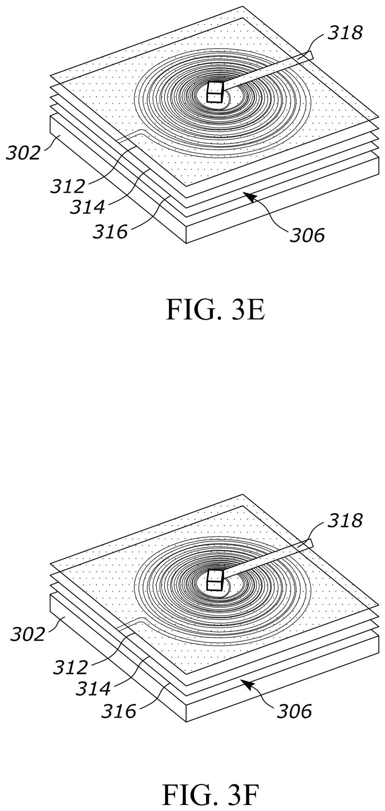

After the additional sensor layers 312, 314, 316 are fabricated on the layer 306, a top interconnect 318 is formed on the dielectric layer 308 of the base film 302 using a printing process as illustrated in FIG. 3E. The printing process may include any suitable printing process to create the top interconnect 318. Suitable printing processes may include, but are not limited to, at least one of aerosol jet printing, micro-dispensing, inkjet printing, or stencil printing. It is contemplated that the top interconnect 318 formed by these processes provide electrically conductive pathways that maintain functionality when the base film 302 is, for example, stretched, bent, or twisted.

Then, the base film 302 is removed from the first layer 306 as illustrated in FIG. 3F. Suitable removal processes may include, but are not limited to, at least one of peeling off the base film 302 via ultraviolet radiation or thermally induced release or via dissolution using water or a solvent when the base film 302 is water soluble. The removal of the base film 302 exposes the printed mid-resolution sensor element 304 on the sensor layer 306 to obtain a free standing, multi-layer stretchable circuit, sensor, or assembly.

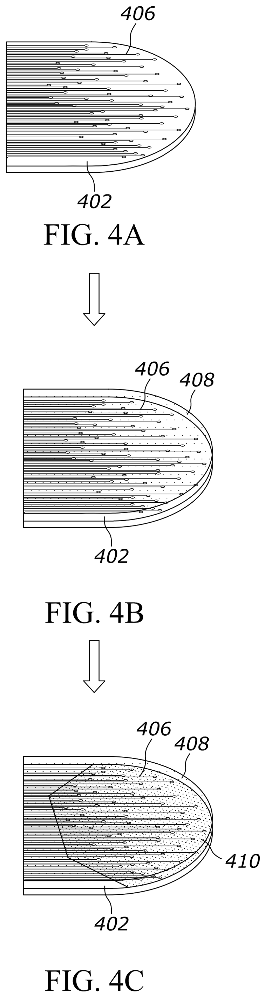

FIGS. 4A-4C illustrate perspective views at various stages of an exemplary method of manufacturing an asymmetrically conductive interconnect for a sensor assembly. In some embodiments, the method of manufacturing may be used to manufacture the asymmetrically conductive interconnect 120 of the sensor assembly as shown in FIGS. 1A-1C. Although the following description of the method of manufacturing is described in a particular order, which represents a particular embodiment, it should be noted that the method of manufacturing may be performed in any suitable order. Further, certain steps may be repeated or skipped altogether, and additional steps may be included.

The method begins with a substrate 402 as illustrated in FIG. 4A. The substrate can be flexible or stretchable. An electrode array 404 is printed on the substrate 402 using a printing process. In some embodiments, the stretchable substrate is the dielectric layer 208 of FIGS. 2B-2F and/or the first layer 102 of FIGS. 1A-1C. The electrode array 404 includes pads (see pads area 406) that form contact points for electrical connections. Suitable printing processes that can be used to form the electrode array 404 may include, but are not limited to, at least one of aerosol jet printing, micro-dispensing, inkjet printing, copper etching, or stencil printing or any other suitable process.

Subsequently, as illustrated in FIG. 4B, a non-conductive dielectric is deposited around the electrode array 404 on the substrate 402. In some approaches, liquid non-conductive dielectric is selectively deposited over the electrode array 404 on the substrate 402, and cured, for example, using heat or UV light to form a non-conductive dielectric film 408.

After the non-conductive dielectric is deposited over the electrode array 404 on the substrate 402, an anisotropic conductive film 410 is formed on the pads area 406 as illustrated in FIG. 4C. This can be done in the simplest case by developing asymmetrical conductivity into the non-conductive dielectric film 408 by aligning magnetically oriented micro-particles pre-embedded in the dielectric film, prior to curing it.

In another embodiment, the anisotropic conductive film 410 is applied on the substrate 402 over the area with point electrodes (e.g., the pads area 406) using a lamination or printing process. In this case the non-conductive dielectric film 408 will not be covering the pads area 406. Suitable printing processes may include, but are not limited to, micro-dispensing, screen-printing, stencil printing, or coating techniques like blade coating or slot-die. The anisotropic conductive film 410 deposited on the pads area 406 has a resolution in the range of about 10 µm to about 100 µm. In some approaches, the anisotropic conductive film 410 is an anisotropically conductive ink. It is contemplated that the anisotropic conductive film 410 will provide selective electrical conductivity in specific directions but will provide electronic insultation in other directions to provide reliable electrical coupling and signal transmission under, for example, mechanical deformation of the stretchable substrate. In some approaches, the anisotropic conductive film 410 and the non-conductive dielectric film 408 can be made of the same material. In the latter embodiment, the asymmetrically conductive dielectric is produced by selectively activating only the region over the pads area 406 (e.g., points electrodes).

In some examples, an anisotropically conductive dry electrode material is disposed over the pads area 406. The formation of the asymmetrical conductive film over an area with point electrodes like the pads area 406 in FIG. 4C can also be used to provide better contact over curved aerospace test samples if the film is the top layer over the entire device, for instance, in an electrical impedance tomography probe. In this manner, the anisotropically conductive dry electrode material form better contact with the aerospace surface under analysis.

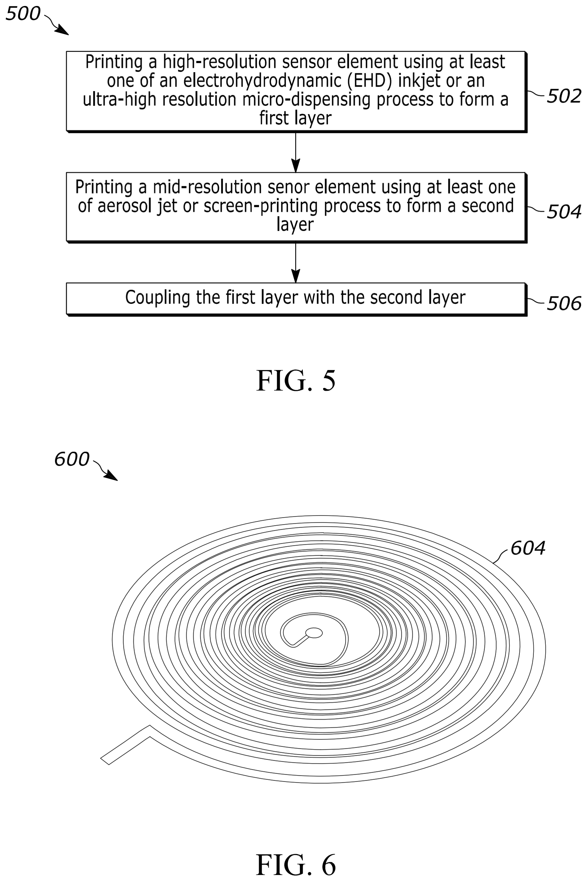

FIG. 5 illustrates an exemplary method 500 of making a flexible, stretchable sensor assembly (e.g., a sensor probe or a sensor array) using printing manufacturing.

At block 502, the method 500 includes printing a high-resolution sensor element using at least one of an electrohydrodynamic (EHD) inkjet or an ultra-high resolution micro-dispensing process. In some approaches, a first substrate is formed on the high-resolution sensor element to from a first layer. In other approaches, the first substrate is a base layer onto which the high-resolution sensor element is printed. In some examples, the first layer is the first layer 102 shown and described with reference to FIGS. 1A-1C. The high-resolution sensor element is printed with a trace spacing of less than about 20 microns. It is contemplated that, using the electrohydrodynamic (EHD) inkjet or an ultra-high resolution micro-dispensing process, the high-resolution sensor element is printed for high-resolution sensing (e.g., eddy current inspection assemblies or electrical impedance tomography) on complex curved surfaces.

The first layer may be a plurality of layers (see FIG. 1B), or alternatively, a single layer (see FIG. 1A). In some examples, the first substrate comprises a stretchable substrate. In other examples, the first substrate comprises a flexible substrate.

In some embodiments, the first layer may be formed by a stack of multiple mid-resolution layers. After printing a first mid-resolution sensor element the first substrate may be formed on the mid-resolution sensor element by laminating the mid-resolution sensor element with a stretchable or a flexible material (e.g., with a thermoplastic polyurethane (TPU) or a silicone material). In other approaches, the first substrate may be formed by depositing a liquid resin on the mid-resolution sensor element by drop-casting or printing.

In some embodiments, after forming the first substrate, at least one via is formed in the first substrate. In some approaches, the via may be formed using a laser. In other approaches, the via may be formed by solvent etching.

In some embodiments, the method 500 further includes printing at least one additional mid-resolution sensor element using at least one of an aerosol, inkjet jet or screen-printing, or copper etching processes. After printing the at least one additional mid-resolution sensor element, the at least one additional mid-resolution sensor element is laminated with a stretchable or a flexible material (e.g., a thermoplastic polyurethane (TPU) or a silicone material) to form at least one additional sensor layer. A base film that is flexible or stretchable can be utilized as a starting material for construction. The at least one additional sensor layer is drilled to form at least one via in the dielectric interlayer. The at least one additional sensor layer may be positioned vertically on top of, or below, the first layer.

The mid-resolution sensor element is printed on the at least one additional sensor layer with a trace spacing in the range of about 20 microns to about 100 microns. The at least one additional sensor layer comprises a stretchable substrate, or alternately, a flexible substrate.

In some approaches, the at least one additional sensor layer includes three additional sensor layers. The additional mid-resolution sensor elements are printed to form the additional sensor layers and the additional sensor layers are subsequently stacked on the first layer. It is contemplated that any suitable number of additional sensors layers may be used (e.g., 2, 3, 6, etc.).

The first layer sensor element may be a single sensor element (see FIG. 1A) or an array of mid-resolution sensor elements (see FIG. 1C).

In some embodiments, after printing the high-resolution sensor element on the first substrate, the first substrate may be formed by laminating the high-resolution sensor element with a stretchable or a flexible material (e.g., a thermoplastic polyurethane (TPU) or a silicone material). A base film that is flexible or stretchable can be utilized as a starting material for construction. In other approaches, the first substrate may be formed by depositing a liquid resin on the high-resolution sensor element by drop-casting or printing.

In some embodiments, after forming the first substrate, at least one via is formed in the first substrate. In some approaches, the via may be formed using a laser. In other approaches, the via may be formed by solvent etching.

In some embodiments, after the via is formed, the via is filled using a printing process. Any suitable printing process may be used. Suitable printing processes include, but are not limited to, aerosol jet printing, micro-dispensing, inkjet printing, or stencil printing.

In some embodiments, after forming the first substrate, a top interconnect is formed on the first substrate using a printing process. Any suitable printing process may be used to print the top interconnect.

At block 504, a mid-resolution sensor element is printed using at least one of an aerosol, inkjet or screen-printing, or copper etching processes. In some approaches, a second substrate is formed on the mid-resolution sensor element to form a second layer. In other approaches, the second substrate is a base layer onto which the mid-resolution sensor element is printed. The mid-resolution sensor element is printed with a trace spacing in the range of about 20 microns to about 100 microns.

The second layer may be a single layer. In some examples, the second substrate comprises a flexible substrate. In other examples, the second substrate comprises a stretchable substrate.

The high-resolution sensor element for the first layer can be printed on the flexible substrate to achieve high-density traces for high-resolution sensing while lower resolution traces can be printed on the stretchable substrate. In this manner, the sensor assembly incorporates a hybrid design with both flexible and stretchable substrates, with the flexible layer providing high-resolution, overcoming printing challenges associated with stretchable substrates, and with the stretchable layer providing stretchability so the array is able to conform to an inspection surface. At block 506, the first layer is coupled with the second sensor layer to form a sensor assembly. In some approaches, the first layer is stacked on top of, or alternatively, below the second layer to form the sensor assembly.

In some embodiments, the method 500 further includes forming an asymmetrically conductive interconnect on the first layer or the second layer. In some examples, the asymmetrically conductive interconnect is the asymmetrically conductive interconnect 120 shown and described with reference to FIGS. 1A-1C. The asymmetrically conductive interconnect may be formed by applying an anisotropic dielectric (e.g., an anisotropic dry electrode) material on the electrode arrays in at least one of a liquid or film form and forming the asymmetrically conductive interconnect between the first layer and the second layer by applying a dry electrode material on the first layer or the second layer in at least one of a liquid or film form.

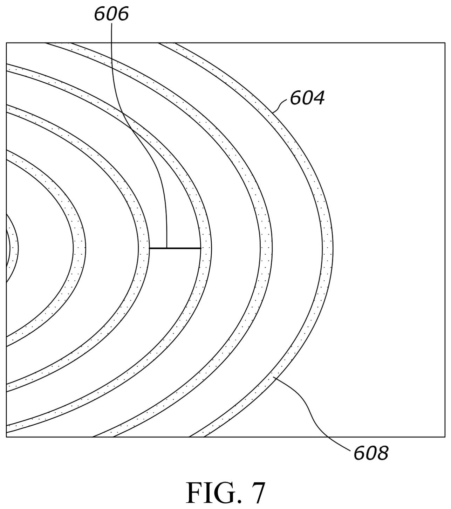

FIGS. 6-7 include an illustration of a high-resolution sensor element printed on a flexible or stretchable substrate using an electrohydrodynamic (EHD) inkjet or ultrahigh-resolution process. FIG. 6 includes a high-resolution sensor element 604. The high-resolution sensor element 604 is a coil having a spiral shape. FIG. 7 includes an enlarged portion of the high-resolution sensor element 604 of FIG. 6. The high-resolution sensor element 604 has a line spacing 606 of 5-10 microns and a line width 608 of 1-10 microns. The line spacing 606 refers to the spacing between adjacent or consecutive turns or loops in the coil.

Further aspects of the disclosure are provided by the subject matter of the following clauses:
A method of making a sensor assembly, the method comprising: printing a high-resolution sensor element using at least one of an electrohydrodynamic (EHD) inkjet or an ultra-high resolution micro-dispensing process and forming a first substrate on the high-resolution sensor element to form a first layer, the first substrate comprising at least one of a flexible or a stretchable material; printing a mid-resolution sensor element using at least one of an aerosol, inkjet jet, screen-printing, or copper etching process and forming a second substrate on the mid-resolution sensor element to form a second layer, the second substrate made from at least one of a stretchable or a flexible material, the mid-resolution sensor element having a trace spacing in the range of about 20 microns to about 100 microns; and coupling the first layer with the second layer to form a sensor assembly.

The method of any preceding clause, wherein the second layer comprises a single layer, and wherein the first layer comprises a single layer or a plurality of layers.

The method of any preceding clause, wherein the second substrate is a dielectric material, and wherein the second substrate is formed by at least one of: utilizing a base film that is stretchable or flexible as a starting material for construction; laminating the mid-resolution sensor element with a stretchable or flexible film; or depositing a liquid resin on the mid-resolution sensor element by drop-casting or printing.

The method of any preceding clause, wherein the method further includes: forming at least one via in the first substrate and/or the second substrate.

The method of any preceding clause, wherein forming the at least one via includes forming at least one via in the first substrate and/or the second substrate using at least one of a laser or solvent etching.

The method of any preceding clause, wherein the method further includes: filling the at least one via using a printing process, wherein the printing process includes at least one of aerosol jet printing, micro-dispensing, inkjet printing, or stencil printing; and coupling at least one additional sensor layer on the second layer or the first layer.

The method of any preceding clause, further comprising: forming a top interconnect on the at least one additional sensor layer using a printing process.

The method of any preceding clause, wherein the mid-resolution sensor element is printed on the base film.

The method of any preceding clause, wherein the method further comprises removing a base film from the first layer.

The method of any preceding clause, wherein the first substrate is a dielectric material, and wherein the first substrate is formed by at least one of: utilizing a base film that is flexible or stretchable as a starting material for construction; laminating the high-resolution sensor element with a stretchable or flexible material; or depositing a liquid resin on the high-resolution sensor element by drop-casting or printing.

The method of any preceding clause, further comprising: drilling at least one via in the first substrate and/or the second substrate.

The method of any preceding clause, further comprising: printing at least one additional mid-resolution sensor element using at least one of an aerosol, inkjet, screen-printing, or copper etching process; laminating at least one additional mid-resolution sensor element with a stretchable or a flexible material to form at least one additional sensor layer; and drilling at least one via in the at least one additional sensor layer.

The method of any preceding clause, further comprising: forming a top interconnect on the at least one additional sensor layer using a printing process.

The method of any preceding clause, wherein the first substrate is a flexible substrate, and wherein the second substrate is a stretchable substrate.

The method of any preceding clause, further comprising: forming an asymmetrically conductive interconnect between the first layer and the second layer.

The method of any preceding clause, wherein the asymmetrically conductive interconnect comprises an anisotropically conductive dielectric ink or film.

A sensor assembly comprising: a first layer including a high-resolution sensor element having a trace spacing of less than about 20 microns; and a second layer including a mid-resolution sensor element having a trace spacing in the range of about 20 microns to about 100 microns; and at least one asymmetrically conductive interconnect disposed between the first layer and the second layer.

The sensor assembly of any preceding clause, wherein the high-resolution sensor element is applied by an electrohydrodynamic (EHD) inkjet or an ultra-high resolution micro-dispensing process.

The sensor assembly of any preceding clause, wherein the mid-resolution sensor element applied by at least one of an aerosol, inkjet, screen-printing, or copper etching process.

The sensor assembly of any preceding clause, further comprising at least one asymmetrically conductive interconnect, the at least one asymmetrically conductive interconnect disposed between the first layer and the second layer.

The sensor assembly of any preceding clause, wherein the at least one asymmetrically conductive interconnect comprises an anisotropically conductive dry electrode material.

The sensor assembly of any preceding clause, wherein the anisotropically conductive dry electrode material is at least one of an anisotropically conductive ink or an anisotropically conductive film.

The sensor assembly of any preceding clause, wherein the anisotopically conductive dry electrode material is disposed on a pads area of the first layer.

The sensor assembly of any preceding clause, wherein the high-resolution sensor element is disposed on a first substrate, and wherein the mid-resolution sensor element is disposed on a second substrate.

The sensor assembly of any preceding clause, wherein the first substrate is at least one of a stretchable or a flexible substrate, and wherein the second substrate is a stretchable substrate.

The sensor assembly of any preceding clause, wherein the first substrate and the second substrate are stretchable substrates.

The sensor assembly of any preceding clause wherein the stretchable substrate comprises at least one of thermoplastic poly-urethanes (TPU), a silicone, or styrene-ethylene-butylene-styrene (SEBS); and wherein the flexible substrate comprises at least one of polyethylene terephthalate (PET), polycarbonate (PC), polyethylene naphthalene (PEN), polyethylene (PE), polypropylene (PP), or polyimide (Kapton).

The sensor assembly of any preceding clause, wherein the high-resolution sensor element includes a sense coil, and wherein the mid-resolution sensor element includes a drive coil.

A sensor assembly comprising: one or more sensors formed according to the method of any preceding clause.

A method of making a sensor assembly, the method comprising: printing a high-resolution sensor element using at least one of an electrohydrodynamic (EHD) inkjet or an ultra-high resolution micro-dispensing process and forming a first substrate on the high-resolution sensor element to form a first layer, the first substrate comprising at least one of a flexible or a stretchable material; printing a mid-resolution sensor element using at least one of an aerosol, inkjet jet, screen-printing, or copper etching process and forming a second substrate on the mid-resolution sensor element to form a second layer, the first substrate made from at least one of a stretchable or a flexible material, the mid-resolution sensor element having a trace spacing in the range of about 20 microns to about 100 microns; and coupling the first layer with the second layer to form a sensor assembly.

The method of any preceding clause, wherein the second layer comprises a single layer, and wherein the first layer comprises a single layer or a plurality of layers.

The method of any preceding clause, wherein the second substrate is a dielectric material, and wherein second substrate is formed by at least one of: utilizing a base film that is stretchable or flexible as a starting material for construction; laminating the mid-resolution sensor element with a stretchable or flexible film; or depositing a liquid resin on the mid-resolution sensor element by drop-casting or printing.

The method of any preceding clause, wherein the method further includes: forming at least one via in the first substrate.

The method of any preceding clause, wherein forming the at least one via includes forming at least one via in the first substrate using at least one of a laser or solvent etching.

The method of any preceding clause, wherein the method further includes: filling the at least one via using a printing process, wherein the printing process includes at least one of aerosol jet printing, micro-dispensing, inkjet printing, or stencil printing; and coupling at least one additional sensor layer on the second layer or the first layer.

The method of any preceding clause, further comprising: forming a top interconnect on the at least one additional sensor layer using a printing process.

The method of any preceding clause, wherein the mid-resolution sensor element is printed on the base film, and wherein the method further comprises removing a base film from the first layer.

The method of any preceding clause, wherein the first substrate is a dielectric material, and wherein the first substrate is formed by at least one of: utilizing a base film that is flexible or stretchable as a starting material for construction; laminating the high-resolution sensor element with a stretchable or flexible material; or depositing a liquid resin on the high-resolution sensor element by drop-casting or printing.

The method of any preceding clause, further comprising: drilling at least one via in the first substrate.

The method of any preceding clause, further comprising: printing at least one additional mid-resolution sensor element using at least one of an aerosol, inkjet, screen-printing, or copper etching process; laminating at least one additional mid-resolution sensor element with a stretchable or a flexible material to form at least one additional sensor layer; and drilling at least one via in the at least one additional sensor layer.

The method of any preceding clause, further comprising: forming a top interconnect on the at least one additional sensor layer using a printing process.

The method of any preceding clause, wherein the first substrate is a flexible substrate, and wherein the second substrate is a stretchable substrate.

The method of any preceding clause, further comprising: forming an asymmetrically conductive interconnect between the first layer and the second layer.

The method of any preceding clause, wherein the asymmetrically conductive interconnect comprises an anisotropically conductive dielectric ink or film.

A sensor assembly comprising: a first layer including a high-resolution sensor element applied by an electrohydrodynamic (EHD) inkjet or an ultra-high resolution micro-dispensing process, the high-resolution sensor element having a trace spacing of less than about 10 microns; and a second layer including a mid-resolution sensor element applied by at least one of an aerosol, inkjet, screen-printing, or copper etching process, the mid-resolution sensor element having a trace spacing in the range of about 20 microns to about 100 microns.

The sensor assembly of any preceding clause, further comprising at least one asymmetrically conductive interconnect, the at least one asymmetrically conductive interconnect disposed between the first layer and the second layer.

The sensor assembly of any preceding clause, wherein the at least one asymmetrically conductive interconnect comprises an anisotropically conductive dry electrode material.

The sensor assembly of any preceding clause, wherein the anisotropically conductive dry electrode material is at least one of an anisotropically conductive ink or an anisotropically conductive film.

The sensor assembly of any preceding clause, wherein the high-resolution sensor element is disposed on a first substrate, and wherein the mid-resolution sensor element is disposed on a second substrate.

The sensor assembly of any preceding clause, wherein the first substrate is a flexible substrate, and wherein the second substrate is a stretchable substrate.

The sensor assembly of any preceding clause, wherein the first substrate and the second substrate are stretchable substrates.

The sensor assembly of any preceding clause, wherein the high-resolution sensor element includes a sense coil, and wherein the mid-resolution sensor element includes a drive coil.

A sensor assembly comprising: one or more sensors formed according to the method of any preceding clause.

A method of making a sensor assembly, the method comprising: printing a high-resolution sensor element using at least one of an electrohydrodynamic (EHD) inkjet or an ultra-high resolution micro-dispensing process and forming a first substrate on the high-resolution sensor element to form a first layer, the first substrate comprising at least one of a flexible or a stretchable material; printing a mid-resolution sensor element using at least one of an aerosol, inkjet jet, screen-printing, or copper etching process and forming a second substrate on the mid-resolution sensor element to form a second layer, the second substrate made from at least one of a stretchable or a flexible material, the mid-resolution sensor element having a trace spacing in the range of about 20 microns to about 100 microns; andcoupling the first layer with the second layer to form a sensor assembly.

The method of any preceding clause, wherein the second layer comprises a single layer, and wherein the first layer comprises a single layer or a plurality of layers.

The method of any preceding clause, wherein the second substrate is a dielectric material, and wherein second substrate is formed by at least one of: utilizing a base film that is stretchable or flexible as a starting material for construction; laminating the mid-resolution sensor element with a stretchable or flexible film; or depositing a liquid resin on the mid-resolution sensor element by drop-casting or printing.

The method of any preceding clause, wherein the method further includes forming at least one via in the first substrate and/or the second substrate using at least one of a laser or solvent etching.

The method of any preceding clause, wherein the method further includes: filling the at least one via using a printing process, wherein the printing process includes at least one of aerosol jet printing, micro-dispensing, inkjet printing, or stencil printing; and coupling at least one additional sensor layer on the second layer or the first layer.

The method of any preceding clause, further comprising: forming a top interconnect on the at least one additional sensor layer using a printing process.

The method of any preceding clause, wherein the mid-resolution sensor element is printed on the base film.

The method of any preceding clause, wherein the first substrate is a dielectric material, and wherein the first substrate is formed by at least one of: utilizing a base film that is flexible or stretchable as a starting material for construction; laminating the high-resolution sensor element with a stretchable or flexible material; or depositing a liquid resin on the high-resolution sensor element by drop-casting or printing.

The method of any preceding clause, further comprising: printing at least one additional mid-resolution sensor element using at least one of an aerosol, inkjet, screen-printing, or copper etching process; laminating at least one additional mid-resolution sensor element with a stretchable or a flexible material to form at least one additional sensor layer; drilling at least one via in the at least one additional sensor layer; and forming a top interconnect on the at least one additional sensor layer using a printing process.

The method of any preceding clause, wherein the first substrate is a flexible substrate, and wherein the second substrate is a stretchable substrate.

The method of any preceding clause, further comprising: forming an asymmetrically conductive interconnect between the first layer and the second layer.

The method of any preceding clause, wherein the asymmetrically conductive interconnect comprises an anisotropically conductive dielectric ink or film.

A sensor assembly comprising: one or more sensors formed according to the method of any preceding clause.

A sensor assembly comprising: a first layer including a high-resolution sensor element having a trace spacing of less than about 20 microns; a second layer including a mid-resolution sensor element having a trace spacing in the range of about 20 microns to about 100 microns; and at least one asymmetrically conductive interconnect disposed between the first layer and the second layer.

The sensor assembly of any preceding clause, wherein the at least one asymmetrically conductive interconnect comprises an anisotropically conductive dry electrode material.

The sensor assembly of any preceding clause, wherein the anisotropically conductive dry electrode material is disposed on a pads area of the first layer.

The sensor assembly of any preceding clause, wherein the high-resolution sensor element is disposed on a first substrate, and wherein the mid-resolution sensor element is disposed on a second substrate.

The sensor assembly of any preceding clause, wherein the first substrate is at least one of a flexible substrate or a stretchable substrate, and wherein the second substrate is a stretchable substrate.

The sensor assembly of any preceding clause, wherein the stretchable substrate comprises at least one of thermoplastic poly-urethanes (TPU), a silicone, or styrene-ethylene-butylene-styrene (SEBS); and wherein the flexible substrate comprises at least one of polyethylene terephthalate (PET), polycarbonate (PC), polyethylene naphthalene (PEN), polyethylene (PE), polypropylene (PP), or polyimide (Kapton).

The sensor assembly of any preceding clause, wherein the high-resolution sensor element includes a sense coil, and wherein the mid-resolution sensor element includes a drive coil.

## Claims

1. A method of making a sensor assembly (100A, 100B, 100C), the method comprising:
printing a high-resolution sensor element (106, 204, 604) using at least one of an electrohydrodynamic (EHD) inkjet or an ultra-high resolution micro-dispensing process and forming a first substrate (104) on the high-resolution sensor element (106, 204, 604) to form a first layer (102, 102B, 206, 306), the first substrate (104) comprising at least one of a flexible or a stretchable material;
printing a mid-resolution sensor element (116, 304) using at least one of an aerosol, inkjet jet, screen-printing, or copper etching process and forming a second substrate (114) on the mid-resolution sensor element (116, 304) to form a second layer (112, 206, 306), the second substrate (114) made from at least one of a stretchable or a flexible material, the mid-resolution sensor element (116, 304) having a trace spacing (606) in the range of about 20 microns to about 100 microns; and
coupling the first layer (102, 102B, 206, 306) with the second layer (112, 206, 306) to form a sensor assembly (100A, 100B, 100C).

2. The method of claim 1, wherein the second layer (112, 206, 306) comprises a single layer, and wherein the first layer (102, 102B, 206, 306) comprises a single layer or a plurality of layers.

3. The method of any preceding claim, wherein the second substrate (114) is a dielectric material (122), and wherein the second substrate (114) is formed by at least one of:
utilizing a base film that is stretchable or flexible as a starting material for construction;
laminating the mid-resolution sensor element (116, 304) with a stretchable or flexible film; or
depositing a liquid resin on the mid-resolution sensor element (116, 304) by drop-casting or printing.

4. The method of claim 3, wherein the method further includes forming at least one via (210, 310) in the first substrate (104) and/or the second substrate (114), and wherein forming the at least one via (210, 310) includes forming at least one via (210, 310) in the first substrate (104) and/or the second substrate (114) using at least one of a laser or solvent etching.

5. The method of claim 4, wherein the method further includes:
filling the at least one via (210, 310) using a printing process, wherein the printing process includes at least one of aerosol jet printing, micro-dispensing, inkjet printing, or stencil printing; and
coupling at least one additional sensor layer (206, 306) on the second layer (112, 206, 306) or the first layer (102, 102B, 206, 306).

6. The method of claim 5, further comprising:
forming a top interconnect (214, 318) on the at least one additional sensor layer (206, 306) using a printing process.

7. The method (500) of claim 6, wherein the mid-resolution sensor element (304) (116, 304) is printed on the base film (302).

8. The method (500) of any preceding claim, wherein the first substrate (104) is a dielectric material (122), and wherein the first substrate (104) is formed by at least one of:
utilizing a base film that is flexible or stretchable as a starting material for construction;
laminating the high-resolution sensor element (106, 204, 604) (204) with a stretchable or flexible material; or
depositing a liquid resin on the high-resolution sensor element (106, 204, 604) by drop-casting or printing.

9. The method of any preceding claim, further comprising:
printing at least one additional mid-resolution sensor element (116, 304) using at least one of an aerosol, inkjet, screen-printing, or copper etching process;
laminating at least one additional mid-resolution sensor element (116, 304) with a stretchable or a flexible material to form at least one additional sensor layer (206, 306);
drilling at least one via (210, 310) in the at least one additional sensor layer (306) (206); and.
forming a top interconnect (214, 318) on the at least one additional sensor layer (306) (206) using a printing process.

10. The method of claim 9, wherein the first substrate (104) is a flexible substrate, and wherein the second substrate (114) is a stretchable substrate.

11. The method of any preceding claim, further comprising:
forming an asymmetrically conductive interconnect (120) between the first layer (102, 102B, 206, 306) and the second layer (112, 206, 306).

12. The method (500) of claim 11, wherein the asymmetrically conductive interconnect (120) comprises an anisotropically conductive dielectric ink or film.

13. A sensor assembly (100A, 100B, 100C) comprising:
a first layer (102, 102B, 206, 306) including a high-resolution sensor element (106, 204, 604) having a trace spacing (606) of less than about 20 microns;
a second layer (112, 206, 306) including a mid-resolution sensor element (116, 304) having a trace spacing (606) in the range of about 20 microns to about 100 microns; and
at least one asymmetrically conductive interconnect (120) disposed between the first layer (102, 102B, 206, 306) and the second layer (112, 206, 306).

14. The sensor assembly (100A, 100B, 100C) of claim 13, wherein the at least one asymmetrically conductive interconnect (120) comprises an anisotropically conductive dry electrode material.

15. The sensor assembly (100A, 100B, 100C) of any of claims 13 to 14, wherein the high-resolution sensor element (106, 204, 604) is disposed on a first substrate (104) and the mid-resolution sensor element (116, 304) is disposed on a second substrate (114), and wherein the first substrate (104) is at least one of a flexible substrate or a stretchable substrate, and wherein the second substrate (114) is a stretchable substrate.
